# EUROPEAN PATENT SPECIFICATION

(11) **EP 3 419 050 B1**
(45) Date of publication and mention of the grant of the patent: **10.06.2026**
(21) Application number: 17177707.1
(22) Date of filing: 23.06.2017
(51) Int. Cl.: H10F 39/00, H10W 42/20, H10W 74/10, H10W 74/40, H10W 76/48, H10W 72/00, H10W 72/30, H10W 72/50, H10W 72/59, H10W 74/01, H10W 76/42, H10W 90/00

(54) **RADIATION-HARDENED PACKAGE FOR AN ELECTRONIC DEVICE**
STRAHLUNGSGEHÄRTETES GEHÄUSE FÜR EINE ELEKTRONISCHE VORRICHTUNG
EMBALLAGE RÉSISTANT AUX RAYONNEMENTS POUR UN DISPOSITIF ÉLECTRONIQUE

(43) Date of publication of application: 26.12.2018
(73) Proprietor: ams International AG, 8645 Jona (CH)
(72) Inventor: Hofrichter, Jens, 8136 Gattikon (CH); Meynants, Guy, 2470 Retie (BE); Pertl, Josef, 8010 Graz (AT); Troxler, Thomas, 8703 Erlenbach (CH)
(74) Representative: Epping - Hermann - Fischer

(56) References cited:
- US-A1- 2005 184 405
- US-A1- 2008 142 932
- US-A1- 2008 249 275
- US-A1- 2010 244 286
- US-A1- 2011 147 902
- US-A1- 2011 175 235
- US-A1- 2014 038 322
- US-A1- 2015 076 670
- US-A1- 2015 091 155
- US-A1- 2016 233 196

## Description

The present invention relates to the field of electronic devices, in particular imaging devices for the detection of high-energy radiation such as X-rays or gamma rays. More specifically, it relates to the fields of computed tomography imaging systems, X-ray flat panel detectors, fluoroscopy, mammography, angiography, positron emission tomography, gamma cameras and other variants of medical imaging devices involving electromagnetic radiation of very short wavelength and ionizing radiation. It also relates to space applications (e. g. satellites), failure analysis or security applications.

Various methods are used to protect sensitive electrical components from X-ray radiation. Shields of a metal with large atomic number, such as tungsten or lead, may be employed for this purpose. The use of such materials are avoided if they are poisonous or too expensive.

US 2007/0189350 A1 discloses a vertical-cavity surface-emitting laser (VCSEL) with a saturable absorber including one or more layers of quantum dots.

US 2012/0250351 A1 discloses a package including a light-emitting diode and a quantum dot layer absorbing a portion of the light-emitted by the diode and emitting light of a different colour.

US 2013/0016499 A1 discloses a package of a light-emitting diode using an optical device including a quantum dot layer formed at an upper surface of a thin film layer.

US 2012/0235198 A1 discloses a package of a light-emitting diode with a housing comprising a wavelength transformation material.

US 2011/0227110 A1 discloses a package of a light-emitting device with reflective layers having a plurality of dielectric layers of different refractive indices.

US 2008/0011349 A1 discloses a photovoltaic device comprising an array of quantum dots and quantum dashes.

US 2015/0153504 A1 discloses a package of light-emitting diodes, at least one of which is covered with an insulating layer formed at least partially of a fluorescent material.

US 2010/0213440 A1 discloses a photodetector comprising a gate dielectric of a nano-structural silicon-base membrane, which is used as infrared light absorber.

WO 2016/097850 A1 discloses a pixel detector including an absorber wafer, which is bonded to a silicon wafer comprising CMOS processed readout electronics.

S. Yakunin et al., "Detection of X-ray photons by solution-processed lead halide perovskites", Nature Photonics 9 (2015), pages 444-449, describe the use of nanoparticles specifically designed for direct X-ray detection.

H. Wei et al., "The Core/Shell Structure of CdSe/ZnS Quantum Dots Characterized by X-Ray Absorption Fine Spectroscopy", Journal of Nanomaterials, 764712 (2015), describe X-ray absorption spectra of quantum dots absorbing energies larger than approximately 12 keV.

G.N. Ankah et al., "PbS quantum dot based hybrid-organic photodetectors for x-ray sensing", Organic Electronics 33 (2016), pages 201-206, describe a fully integrated X-ray detector using the absorption properties for PbS quantum dots. The detector is configured to generate a photocurrent that can be measured electronically.

US 2015/076670 A1 discloses a chip package structure.

US 2010/244286 A1 discloses nanocomposites for optoelectronic devices. US 2010/244286 discloses an electronic device comprising a nanomaterial cover made from ZnS.

US 2008/142932 A1 discloses a semiconductor device.

US 2005/184405 A1 discloses a semiconductor package.

US 2011/147902 A1 discloses an integrate circuit comprising a light absorbing adhesive.

US 2014/038322 A1 discloses an electronic device.

US 2016/233196 A1 discloses a semiconductor package.

US 2011/175235 A1 discloses a semiconductor apparatus.

US 2015/091155 A1 discloses a chip embedded package

US 2008/249275 A1 discloses shielding electronics from damage by X-rays, and the use of metal particles containing CdS, CdSe, CdTe, ZnS, PbS, but does not link X-ray shielding and the metal particles, and does not disclose the metal particles being nanoparticles.

It is an object of the present invention to provide a radiation-hardened package for an electronic device.

This object is achieved with the package for an electronic device according to claim 1. Embodiments and variants derive from the dependent claims.

In the following description and in the claims, the term "nanomaterial" is meant to include any material comprising nanoparticles. The nanomaterial can especially comprise nanodots, nanorods, nanowires, quantum dots, quantum rods or any combination thereof.

In the following description and in the claims, the term "carrier" is meant to include a printed circuit board (PCB), a laminate, a flex circuit, a substrate or an interposer.

The absorption spectrum of quantum dots or other nanoparticles can be tuned to absorb radiation of defined wavelengths, like X-ray radiation, for instance, by appropriately selecting their material, material composition, size and shape. Furthermore, nanoparticles can easily be mixed with polymers, glues and other organic substances that are used to form housings of packages, like glob tops or injection-molded covers. These properties of nanoparticles may be employed in a radiation-hardened package.

According to an aspect, the package for an electronic device comprises a carrier, an electronic device arranged on the carrier, and a cover on the carrier, the carrier and the cover forming a cavity accommodating the electronic device. The cover comprises nanomaterial or is provided with an absorber film comprising nanomaterial. The cover may especially be a glob top or part of a glob top. The cover may instead be injection-molded. The cover may also comprise plastic or ceramic.

An embodiment of the package comprises an adhesive layer between the carrier and the electronic device, the adhesive layer comprising nanomaterial.

In a further aspect, the package for an electronic device comprises a carrier, an electronic device arranged on the carrier and an adhesive layer arranged between the carrier and the electronic device. The adhesive layer comprises nanomaterial. In particular, the adhesive layer serves to fasten the electronic device to the carrier.

In still a further aspect, the package for an electronic device comprises a carrier, an electronic device arranged on the carrier and an absorber film comprising nanomaterial. The absorber film is arranged on the electronic device on a side facing away from the carrier.

In further embodiments of the package, a further electronic device is arranged on the carrier on a side opposite the electronic device. The further electronic device is provided with a cover comprising nanomaterial, with an absorber film comprising nanomaterial, or with an adhesive layer comprising nanomaterial.

A further embodiment comprises an integrated circuit in the electronic device and a photodiode in the further electronic device, the integrated circuit being configured as a read-out circuit for the photodiode.

A further embodiment comprises an interconnection in the carrier, the interconnection electrically connecting the electronic device and the further electronic device.

The nanomaterial comprises PbS, PbSe, CdSe, CdTe, copper sulfide, copper oxide, organic perovskites or inorganic perovskites, or any combination thereof. In an example not forming part of the claimed invention, the nanomaterial may comprise ZnS. The nanomaterial may include nanodots, nanorods, nanowires, or any combination thereof. The nanorods, nanowires and nanodots may be formed to have at least one dimension that is smaller than 1000 nm, smaller than 100 nm, or even smaller than 10 nm.

The package for an electronic device comprises:
a carrier, and
an electronic device arranged on the carrier,
the package further comprising:
   a cover over the electronic device, the cover comprising nanomaterial or being provided with an absorber film comprising nanomaterial, or
   an absorber film comprising nanomaterial on the electronic device on a side facing away from the carrier, or
   an adhesive layer comprising nanomaterial between the carrier and the electronic device,
   characterized in that
   the nanomaterial comprised by the cover, the absorber film or the adhesive layer is tuned to absorb X-radiation, such that the package shields the electronic device against X-radiation, and
   the nanomaterial comprises a material of the group consisting of PbS, PbSe, CdSe, CdTe, copper sulfide, copper oxide, organic perovskites and inorganic perovskites, or any combination thereof.

A non-claimed method of producing a package for an electronic device comprises arranging an electronic device on a carrier and applying a glob top or an injection-molded cover over the electronic device, the glob top or injection-molded cover being formed to include nanomaterial.

In a further aspect, the non-claimed method of producing a package for an electronic device comprises arranging an electronic device on a carrier, applying a glob top or an injection-molded cover over the electronic device, and applying an absorber film that is formed from nanomaterial on the glob top or injection-molded cover.

In still a further aspect, the non-claimed method of producing a package for an electronic device comprises mounting an electronic device on a carrier by means of an adhesive layer, and forming the adhesive layer including nanomaterial.

In still a further aspect, the non-claimed method of producing a package for an electronic device comprises arranging an electronic device on a carrier, and applying an absorber film formed from nanomaterial on the electronic device on a side facing away from the carrier.

The following is a detailed description of examples of the radiation-hardened package and the manufacturing method in conjunction with the appended figures.
- Figure 1: is a cross section of a radiation-hardened package with a glob top comprising nanomaterial.
- Figure 2: is a cross section of a radiation-hardened package with an injection-molded cover comprising nanomaterial.
- Figure 3: is a cross section of a radiation-hardened package with an injection-molded cover and an absorber film comprising nanomaterial.
- Figure 4: is a cross section of a radiation-hardened package with an adhesive layer comprising nanomaterial.
- Figure 5: is a cross section of a radiation-hardened package with an absorber film comprising nanomaterial applied to a semiconductor chip or die.
- Figure 6: is a cross section of a further radiation-hardened package with an absorber film comprising nanomaterial applied to a semiconductor chip or die.
- Figure 7: is a cross section of an assembly of radiation-hardened packages with adhesive layers comprising nanomaterial.
- Figure 8: is a cross section of an assembly of radiation-hardened packages with adhesive layers comprising nanomaterial and a glop top comprising a nanomaterial.

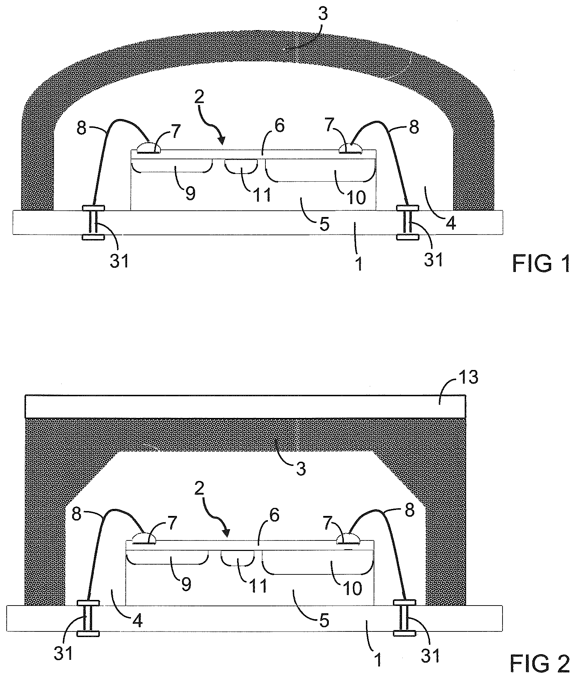

Figure 1 is a cross section of a radiation-hardened package with a glob top comprising a nanomaterial. The electronic device 2 is mounted on a carrier 1, which may be a printed circuit board (PCB), a laminate, a flex circuit, a substrate or an interposer, for instance. A cover 3 comprising nanomaterial is arranged on or above the carrier 1. The electronic device 2 is located in a cavity 4 formed by the cover 3.

The cover 3 may comprise a plastic or flexible basic material, in particular a material that is suitable for a glob top, such as a polymer, for instance. In this case, the cavity 4 is optionally filled with a further material. If the cover 3 is formed from a sufficiently rigid material, the volume of the cavity 4 surrounding the electronic device 2 can be filled with a gas or vacuum.

The package according to Figure 1 may be produced by embedding the electronic device 2 in a glob top and applying the cover 3 on the glob top. Thus the cavity 4 is filled with the material of the glob top. The basic material of the cover 3 may be a material that is also suitable for a glob top like a polymer, for instance.

The cover 3 contains nanoparticles for X-ray absorption, in particular scintillating nanoparticles, which absorb X-ray radiation and re-emit visible light. The electronic device 2 may be encapsulated in a conventional black, non-transparent glob top filling the cavity 4, and the cover 3 is provided for enhanced X-ray absorption.

The electronic device 2 may comprise a substrate 5 of semiconductor material with a BEOL (back end of line) layer 6 including at least one wiring. Solder balls 7 can be provided for electric connections by bonding wires 8, for instance. The bonding wires 8 may be connected to interconnections 31 arranged in the carrier 1 for external electric connection, for instance.

The electronic device 2 may comprise various integrated components, like a photodetector 9, an integrated circuit 10 and a guard ring 11, as shown in Figure 1 by way of example. The integrated components may particularly be provided for a computed tomography (CT) detector, for instance.

Figure 2 is a cross section of a radiation-hardened package with an injection-molded cover comprising nanomaterial. Elements of the embodiment according to Figure 2 that correspond to elements of the embodiment according to Figure 1 are designated with the same reference numerals. In the embodiment according to Figure 2, the cover 3 is an injection-molded cover 3. The volume of the cavity 4 surrounding the electronic device 2 may be left empty, or it may be filled with a solid material, in particular with a suitable blackout material, like a polymer, for instance.

An absorber film 13 comprising nanomaterial may be applied on the cover 3. A film thickness of 1 mm is maximally required if radiation having an energy of not more than 150 keV is to be shielded by a quantum dot absorber film with hexagonal closest packing. If a sufficiently thick absorber film 13 comprising nanomaterial is present, the cover 3 may be formed from any material that is conventionally used for an injection-molded cover. In this case, the absorber film 13 especially comprises nanoparticles absorbing X-radiation, while the injection-molded cover 3 may absorb visible, ultraviolet or infrared light. If no absorber film 13 is applied, the injection-molded cover 3 is formed from nanomaterial.

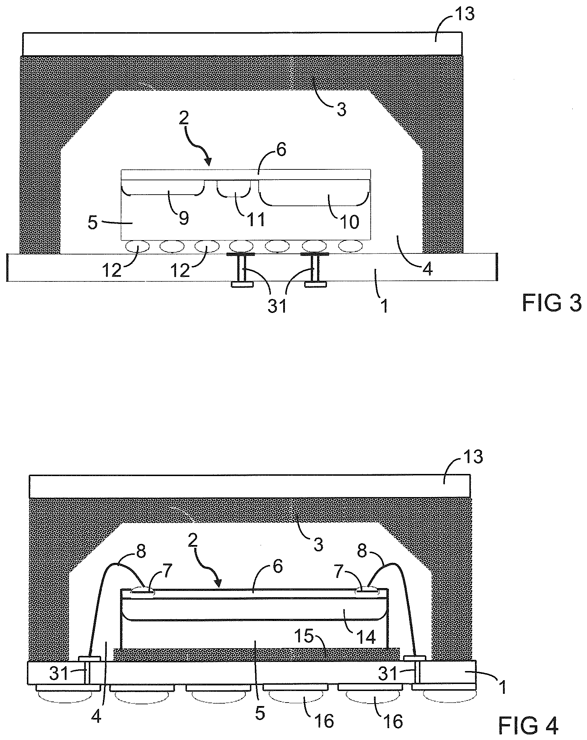

Figure 3 is a cross section of a further radiation-hardened package with an injection-molded cover. Elements of the embodiment according to Figure 3 that correspond to elements of the embodiment according to Figure 2 are designated with the same reference numerals. In the embodiment according to Figure 3, electric connections between the integrated components of the electronic device 2 and the interconnections 31 in the carrier 1 are provided by solder balls 12 at the bottom of the substrate 5, which comprises through-substrate vias forming electric interconnections between the integrated components and the solder balls 12.

In the embodiment according to Figure 3, the injection-molded cover 3 comprises nanomaterial. An absorber film 13 comprising nanomaterial may instead or additionally be applied as in the embodiment according to Figure 2. Figure 4 is a cross section of a radiation-hardened package with an adhesive layer comprising nanomaterial. Elements of the embodiment according to Figure 4 that correspond to elements of the embodiment according to Figure 2 are designated with the same reference numerals. In the embodiment according to Figure 4, the electronic device 2 and in particular the substrate 5 is mounted on the carrier 1 by means of an adhesive layer 15 comprising nanomaterial. The adhesive layer 15 may especially comprise an electrically conductive glue comprising nanoparticles.

In the embodiment according to Figure 4, the cover 3 may be an injection-molded cover, as shown in Figure 4 by way of example, or a glob top as in the embodiment according to Figure 1. The cover 3 also comprises nanomaterial, which may include the same kind of nanoparticles as the adhesive layer 15 or a different kind of nanoparticles. An absorber film 13 comprising nanomaterial may instead or additionally be applied as in the embodiment according to Figure 3.

In the embodiment according to Figure 4, pads 7 and wire bonds 8 may be provided for the electric connections between components of an integrated circuit 14 and the interconnections 31 in the carrier 1. Instead, solder balls 12 at the bottom of the substrate 5 may be used as in the embodiment according to Figure 3. The solder balls 12 can be arranged in openings of the adhesive layer 15. If the adhesive layer 15 is electrically conductive, it may be structured to form individual electric connections between the electronic device 2 and interconnections of the carrier 1. Figure 4 shows further solder balls 16 at the bottom surface of the carrier 1 for external electric connection.

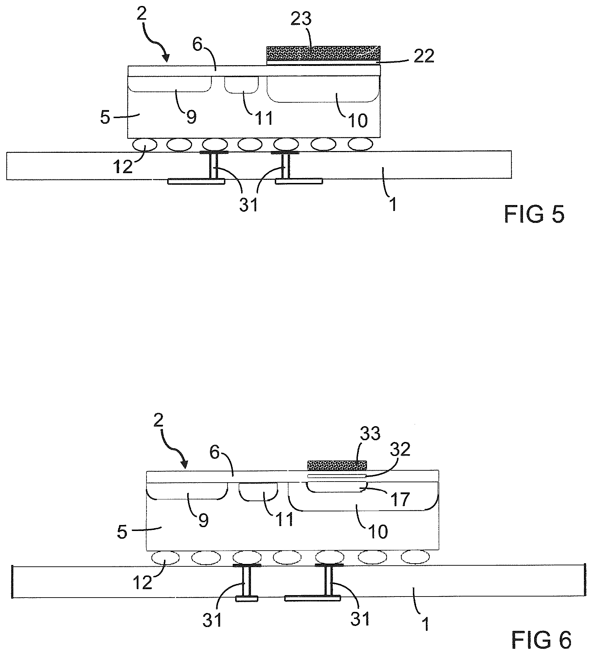

Figure 5 is a cross section of a radiation-hardened package with an absorber film comprising nanomaterial applied to a semiconductor chip, wafer level chip scale package or die. The electronic device 2 is mounted on a carrier 1, which may be a printed circuit board (PCB), a laminate, a flex circuit, a substrate or an interposer, for instance. The electronic device 2 may comprise a substrate 5 of semiconductor material with a BEOL (back end of line) layer 6 including a wiring. Solder balls 12 providing electric connections can be arranged at the bottom of the substrate 5 and electrically connected to interconnections 31 in the carrier 1, for instance. The electronic device 2 may comprise various integrated components, like a photodetector 9, an integrated circuit 10 and a guard ring 11, as shown in Figure 5 by way of example.

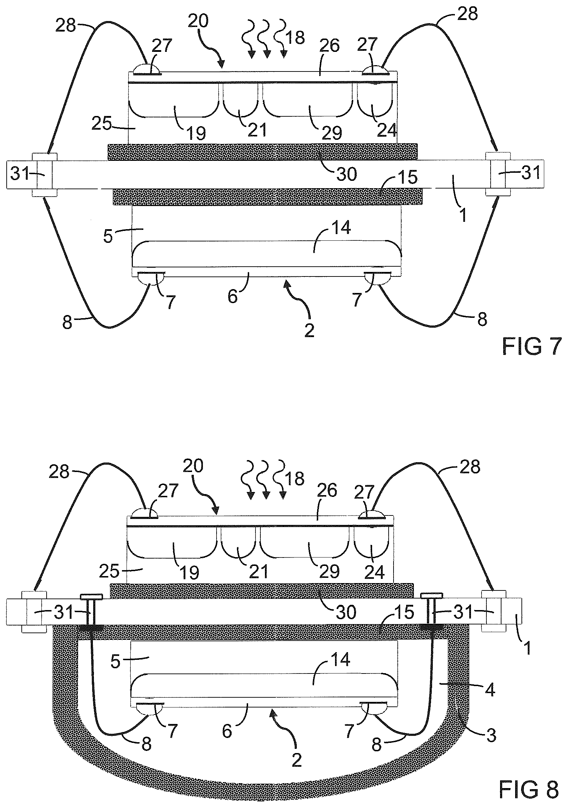

Figure 5 shows a solution with bump bonds at the bottom, such as may be used in practice with wafer level packaging technology, in combination with through silicon vias (TSVs) and a backside redistribution layer to connect the bond pads to the wire bumps. Other packaging techniques could be used, such as wire bonding (similar to Figure 7) or flip chip technology. The absorber film may be deposited on wafer during or at the end of the wafer processing, or during assembly of the chip in its package.

A shield 22, in particular a light shield, which may be formed from aluminum, copper, tungsten, or any combination thereof, is arranged on the electronic device 2. An absorber film 23 comprising nanomaterial is applied on or above the shield 22. The shield 22 and the absorber film 23 may especially be arranged on a partial area of the upper surface of the electronic device 2. Figure 5 shows the shield 22 and the absorber film 23 arranged above the integrated circuit 10, by way of example. The shield 22 prevents light emitted by the nanomaterial of the absorber film 23 from influencing the integrated circuit 10.

Figure 6 is a cross section of a further radiation-hardened package with an absorber film comprising nanomaterial. Elements of the embodiment according to Figure 6 that correspond to elements of the embodiment according to Figure 5 are designated with the same reference numerals. In the embodiment according to Figure 6, a shield 32, in particular a light shield, which may be formed from aluminum, copper, tungsten, or any combination thereof, is arranged in the BEOL layer 6. The shield 32 may especially be formed by a metallization layer of a wiring. Thus the shield 32 is embedded in the BEOL layer 6. An absorber film 33 comprising nanomaterial is applied on the BEOL layer 6 above the shield 32. The shield 32 and the absorber film 33 may especially be arranged above a transistor 17, which forms a component of the integrated circuit 10, for example. The shield 32 prevents light emitted by the nanomaterial of the absorber film 33 from influencing the transistor 17 or other components of the integrated circuit 10.

Figure 7 is a cross section of an assembly of radiation-hardened packages with adhesive layers 15, 30 comprising nanomaterial. The electronic device 2 and a further electronic device 20 are mounted on opposite surfaces of the carrier 1. Each of the electronic devices 2, 20 may particularly be any of the embodiments described above. In the example of Figure 7, the electronic device 2 comprises an integrated circuit 14, and the further electronic device 20 comprises photodetectors 19, 29 and guard rings 21, 24. The electric connections include pads 7, 27 and wire bonds 8, 28 to the interconnections 31 in the carrier 1. In particular, terminals of the electronic device 2 and further terminals of the further electronic device 20 may thus be interconnected, as shown in Figure 7. The electric connections may differ from the example shown in Figure 7, according to the requirements of individual embodiments and applications. In the example shown in Figure 7, the upper surface of the further electronic device 20 is provided for incidence of radiation 18.

In the assembly according to Figure 7, the electronic devices 2, 20 are both mounted to the carrier 1 by means of adhesive layers 15, 30 comprising nanomaterial. The adhesive layers 15, 30 can comprise the same nanomaterial or different kinds of nanomaterial.

Figure 8 is a cross section of an assembly of radiation-hardened packages with adhesive layers comprising nanomaterial and a glob top comprising nanomaterial. Elements of the embodiment according to Figure 8 that correspond to elements of the embodiment according to Figure 7 are designated with the same reference numerals. In the embodiment according to Figure 8, the electronic device 2 is covered by a glob top, and the cover 3 comprising nanomaterial is applied on the glob top. The cover 3 may instead be an injection-molded cover, and the cavity 4 formed by the cover 3 may be left empty, according to some of the embodiments described above.

The electronic device 2 is mounted to the carrier 1 by means of an adhesive layer 15, which may also comprise nanomaterial. The further electronic device 20 is mounted to the carrier 1 by means of a further adhesive layer 30, which may also comprise nanomaterial. The adhesive layers 15, 30 and the cover 3 can comprise the same nanomaterial or different kinds of nanomaterial. In the embodiment according to Figure 8, the substrate 25 of the further electronic device 20 does not extend laterally over the package formed by the electronic device 2 and its cover 3. Electric connections by pads 7, 27, wire bonds 8, 28 and interconnections 31 of the carrier 1 are only schematically indicated in Figure 8 as examples and may be varied according to the requirements of individual embodiments and applications.

The described package improves the shielding of electronic devices from X-ray radiation at low cost. It can be produced by method steps known per se in semiconductor technology, in particular from the manufacture of consumer electronics.

### List of reference numerals

- 1: carrier
- 2: electronic device
- 3: cover
- 4: cavity
- 5: substrate
- 6: BEOL layer
- 7: pad
- 8: wire bond
- 9: photodetector
- 10: integrated circuit
- 11: guard ring
- 12: solder ball
- 13: absorber film
- 14: integrated circuit
- 15: adhesive layer
- 16: solder ball
- 17: transistor
- 18: radiation
- 19: photodetector
- 20: electronic device
- 21: guard ring
- 22: shield
- 23: absorber film
- 24: guard ring
- 25: substrate
- 26: BEOL layer
- 27: pad
- 28: wire bond
- 29: photodetector
- 30: adhesive layer
- 31: interconnection
- 32: shield
- 33: absorber film

## Claims

1. A package for an electronic device, comprising:
a carrier (1), and
an electronic device (2) arranged on the carrier (1),
the package further comprising:
a cover (3) over the electronic device (2), the cover (3) comprising nanomaterial or being provided with an absorber film (13) comprising nanomaterial, or
an absorber film (23, 33) comprising nanomaterial on the electronic device (2) on a side facing away from the carrier (1), or
an adhesive layer (15) comprising nanomaterial between the carrier (1) and the electronic device (2),
wherein
the nanomaterial comprised by the cover (3), the absorber film (13, 23, 33) or the adhesive layer (15) is tuned to absorb X-radiation, such that the package shields the electronic device (2) against X-radiation, and
the nanomaterial comprises a material of the group consisting of PbS, PbSe, CdSe, CdTe, copper sulfide, copper oxide, organic perovskites and inorganic perovskites, or any combination thereof.

2. The package according to claim 1, further comprising:
a further electronic device (20) is arranged on the carrier (1) on a side opposite the electronic device (2), the further electronic device (20) being provided with a cover (3) comprising nanomaterial, with an absorber film (13, 23, 33) comprising nanomaterial, or with an adhesive layer (30) comprising nanomaterial.

3. The package of claim 2, further comprising:
an integrated circuit (14) in the electronic device (2), and a photodiode (19, 29) in the further electronic device (20), the integrated circuit (14) being configured as a read-out circuit for the photodiode (19, 29).

4. The package of claim 2 or 3, further comprising:
an interconnection (31) in the carrier (1), the interconnection (31) electrically connecting the electronic device (2) and the further electronic device (20).

## Patentansprüche

1. Ein Gehäuse für ein elektronisches Bauteil, aufweisend:
einen Träger (1), und
ein elektronisches Bauteil (2), das auf dem Träger (1) angeordnet ist,
wobei das Gehäuse weiterhin aufweist:
eine Abdeckung (3) über dem elektronischen Bauteil (2), wobei die Abdeckung (3) ein Nanomaterial aufweist oder mit einer Absorberfolie (13) versehen ist, die ein Nanomaterial aufweist, oder
eine Nanomaterial aufweisende Absorberfolie (23, 33) auf dem elektronischen Bauteil (2) auf einer vom Träger (1) abgewandten Seite, oder
eine Nanomaterial aufweisende Klebeschicht (15) zwischen dem Träger (1) und dem elektronischen Bauteil (2),
wobei
das Nanomaterial, das in der Abdeckung (3), der Absorberfolie (13, 23, 33) oder der Klebeschicht (15) enthalten ist, dazu abgestimmt ist, Röntgenstrahlung zu absorbieren, so dass das Gehäuse das elektronische Bauteil (2) gegen Röntgenstrahlung abschirmt, und
das Nanomaterial ein Material aus der Gruppe bestehend aus PbS, PbSe, CdSe, CdTe, Kupfersulfid, Kupferoxid, organischen Perowskiten und anorganischen Perowskiten oder einer beliebigen Kombination davon aufweist.

2. Das Gehäuse nach Anspruch 1, ferner aufweisend:
ein weiteres elektronisches Bauteil (20), das auf dem Träger (1) auf einer dem elektronischen Bauteil (2) gegenüberliegenden Seite angeordnet ist, wobei das weitere elektronische Bauteil (20) mit einer Nanomaterial aufweisenden Abdeckung (3), mit einer Nanomaterial aufweisenden Absorberfolie (13, 23, 33), oder mit einer Nanomaterial aufweisenden Klebeschicht (30) versehen ist.

3. Das Gehäuse nach Anspruch 2, ferner aufweisend:
eine integrierte Schaltung (14) in dem elektronischen Bauteil (2), und
eine Fotodiode (19, 29) in dem weiteren elektronischen Bauteil (20), wobei die integrierte Schaltung (14) als Ausleseschaltung für die Fotodiode (19, 29) eingerichtet ist.

4. Das Gehäuse nach Anspruch 2 oder 3, ferner aufweisend:
eine Zwischenverbindung (31) in dem Träger (1), wobei die Zwischenverbindung (31) das elektronische Bauteil (2) und das weitere elektronische Bauteil (20) elektrisch verbindet.

## Revendications

1. Emballage pour un dispositif électronique, comprenant un support (1), et
un dispositif électronique (2) disposé sur le support (1), l'emballage comprend en outre
un couvercle (3) recouvrant le dispositif électronique (2), le couvercle (3) comprenant un nanomatériau ou étant pourvu d'un film absorbant (13) comprenant un nanomatériau, ou
un film absorbant (23, 33) comprenant du nanomatériau sur le dispositif électronique (2) sur une face opposée au support (1), ou
une couche adhésive (15) comprenant du nanomatériau entre le support (1) et le dispositif électronique (2),
dans lequel
le nanomatériau constitué par le couvercle (3), le film absorbant (13, 23, 33) ou la couche adhésive (15) est réglé pour absorber le rayonnement X, de sorte que l'emballage protège le dispositif électronique (2) contre le rayonnement X, et
le nanomatériau comprend un matériau du groupe constitué de PbS, PbSe, CdSe, CdTe, sulfure de cuivre, oxyde de cuivre, pérovskites organiques et pérovskites inorganiques, ou toute combinaison de ceux-ci.

2. L'emballage selon la revendication 1, comprenant en outre: un autre dispositif électronique (20) est disposé sur le support (1) sur une face opposée au dispositif électronique (2), l'autre dispositif électronique (20) étant pourvu d'un couvercle (3) comprenant un nanomatériau, d'un film absorbant (13, 23, 33) comprenant un nanomatériau, ou d'une couche adhésive (30) comprenant un nanomatériau.

3. L'emballage de la revendication 2, comprenant en outre
un circuit intégré (14) dans le dispositif électronique (2), et
une photodiode (19, 29) dans l'autre dispositif électronique (20), le circuit intégré (14) étant configuré comme un circuit de lecture pour la photodiode (19, 29).

4. L'emballage de la revendication 2 ou 3, comprenant en outre:
une interconnexion (31) dans le support (1), l'interconnexion (31) reliant électriquement le dispositif électronique (2) et le dispositif électronique supplémentaire (20).
